# EUROPEAN PATENT APPLICATION

(11) **EP 3 890 040 A1**
(43) Date of publication of application: **06.10.2021**
(21) Application number: 19889256.4
(22) Date of filing: 18.10.2019
(51) Int. Cl.: H01L 51/44, H01L 51/48

(54) **ORGANIC SOLAR CELL MODULE, METHOD FOR MANUFACTURING SAME, ELECTRONIC DEVICE, OPTICAL SENSOR, AND IMAGING DEVICE**

(30) Priority: 26.11.2018 JP 2018220033
(71) Applicant: Toray Industries, Inc., Tokyo, 103-8666 (JP)
(72) Inventor: YAMAMOTO, Shuhei, Otsu-shi, Shiga 520-8558 (JP); KITAZAWA, Daisuke, Otsu-shi, Shiga 520-8558 (JP)
(74) Representative: Kador & Partner PartG mbB
(86) International application number: PCT/JP2019/041119
(87) International publication number: WO 2020/110511

(57) **Abstract**

An object of the present invention is to provide an organic solar cell module having high durability. A main object of the present invention is an organic solar cell module including at least one photovoltaic element arranged therein, the photovoltaic element including at least a first electrode (2), an organic layer (3), and a second electrode (4) in this order, wherein the organic layer (3) has an organic layer extension part (31) located inside an outer edge of the first electrode (2) and outside an outer edge of the second electrode (4), and in plan view from a second electrode (4) side, a portion of the organic layer extension part (31) facing an outer edge of the organic solar cell module has a width of 20 µm or less.

## Description

### TECHNICAL FIELD

The present invention relates to an organic solar cell module.

### BACKGROUND ART

Currently, inorganic substances such as monocrystal silicon, polycrystal silicon, amorphous silicon, and compound semiconductors are used as a semiconductor material of a photoelectric conversion element of solar cells. Solar cells manufactured using inorganic semiconductors, however, are of high cost, and thus have not been widely spread to ordinary households. The main reason for the high cost lies in the process of manufacturing a semiconductor thin film under vacuum and high temperature. Under such circumstances, organic solar cells have been studied. The organic solar cells contain, as a semiconductor material expected to simplify the process of manufacturing a semiconductor thin film, organic semiconductors such as conjugated compounds and organic crystals as well as organic dyes.

However, organic solar cells are more susceptible to the influence of ambient water and oxygen than conventional solar cells based on inorganic semiconductors, and have a problem in durability. This is probably because an organic compound that makes up an organic solar cell contains water and oxygen, so that photogenerated carriers (electrons and holes) are trapped by the water and oxygen molecules contained in the organic compound, or the organic compound is modified by the oxidation of the film itself.

Therefore, in order to improve the durability of the organic solar cell, it is important to prevent the invasion of water and oxygen from the outside. Examples of the prevention method under consideration include a method of laminating a base material having high gas barrier performance (such as a glass material or a high gas barrier film) onto an operating part of a solar cell, and a method of forming a film having high gas barrier performance (such as a silicon nitride film or a silicon oxide film) on an operating part of a solar cell (for example, Patent Documents 1 and 2).

### PRIOR ART DOCUMENTS

### PATENT DOCUMENTS

Patent Document 1: Japanese Patent Laid-open Publication No. 2013-168572
Patent Document 2: Japanese Patent Laid-open Publication No. 2015-167226

### SUMMARY OF THE INVENTION

### PROBLEMS TO BE SOLVED BY THE INVENTION

As a result of studies made by the present inventors, laminating a film having high gas barrier performance onto an operating part of a solar cell exhibited a certain effect of improving durability. The effect, however, was insufficient for practical use. An object of the present invention is to further improve the durability of an organic solar cell.

### SOLUTIONS TO THE PROBLEMS

The present inventors thought that one of the reasons for the limited effect of improving durability, which is exerted by laminating a gas barrier film, lies in the water and oxygen horizontally invading into an organic compound-containing layer that makes up the operating part of the solar cell. The present invention adopts the following configuration. More specifically, the present invention provides an organic solar cell module including at least one photovoltaic element arranged therein, the photovoltaic element including at least a first electrode, an organic layer, and a second electrode in this order, wherein the organic layer has an organic layer extension part located inside an outer edge of the first electrode and outside an outer edge of the second electrode, and in plan view from the second electrode side, a portion of the organic layer extension part facing an outer edge of the organic solar cell module has a width of 20 µm or less.

### EFFECTS OF THE INVENTION

According to the present invention, it is possible to provide an organic solar cell module having excellent durability. Further, it is also possible to provide an electronic device, an optical sensor, and an imaging device including the organic solar cell module.

### BRIEF DESCRIPTION OF THE DRAWINGS

Figs. 1(a) and 1(b) are schematic views showing an embodiment of an organic solar cell module of the present invention in which one photovoltaic element is arranged.
Figs. 2(a) and 2(b) are schematic views showing an embodiment of the organic solar cell module of the present invention in which four photovoltaic elements are arranged.
Figs. 3(a) and 3(b) are schematic views showing an embodiment of the organic solar cell module of the present invention in which four photovoltaic elements are arranged.
Figs. 4(a) to 4(e) are schematic views showing a process for producing the organic solar cell module according to the embodiment shown in Figs. 3(a) and 3(b).
Figs. 5(a) to 5(f) are schematic views showing a process for producing the organic solar cell module of Example 1.
Fig. 6 shows a laser microscope observation image of an outer edge of an organic layer and an outer edge of a second electrode in the organic solar cell module produced in Example 1, and a cross-sectional profile of a 100 µm field of view in the observation image.

### EMBODIMENTS OF THE INVENTION

The organic solar cell module of the present invention includes at least one photovoltaic element arranged therein, the photovoltaic element including at least a first electrode, an organic layer, and a second electrode in this order. The organic layer has a part located inside an outer edge of the first electrode and outside an outer edge of the second electrode (the part is referred to as an "organic layer extension part"), and in plan view from the second electrode side, a portion of the organic layer extension part facing an outer edge of the organic solar cell module, that is, the organic layer extension part facing the outer edge of the organic solar cell module has a width of 20 µm or less. Herein, in the photovoltaic element of the organic solar cell module, as a layer containing an organic compound, a photoelectric conversion layer containing an electron-donating organic semiconductor or an electron-accepting organic semiconductor may have, in contact with the photoelectric conversion layer and in between the photoelectric conversion layer and electrodes on both sides, an electron extraction layer and a hole extraction layer, and these layers may also contain an organic compound. In the present specification, among the photoelectric conversion layer, the electron extraction layer, and the hole extraction layer, layers in which 50% or more by number of atoms of the constituent elements are carbon and hydrogen are collectively referred to as an "organic layer". More specifically, when the photovoltaic element includes neither the electron extraction layer nor the hole extraction layer, the "organic layer" refers to the photoelectric conversion layer (in the case of an organic solar cell module, usually 50% or more of the constituent elements are carbon and hydrogen) alone. When the photovoltaic element includes at least one of the electron extraction layer and the hole extraction layer, the "organic layer" refers to a laminated structure that is a combination of the electron extraction layer and/or the hole extraction layer in which 50% or more by number of atoms of the constituent elements are carbon and hydrogen, with the photoelectric conversion layer. The constituent elements in these layers may be analyzed, for example, by combinational analyses of scanning electron microscopy (SEM) and energy dispersive X-ray analysis (EDX, EDS), or analysis methods such as fluorescent X-ray analysis, inductively coupled plasma mass spectrometry (ICP-MS), inductively coupled plasma atomic emission spectroscopy (ICP-AES), X-ray photoelectron spectroscopy (XPS), secondary ion mass spectrometry (SIMS), and electron probe microanalysis (EPMA).

In general, in the observation of a photovoltaic element including an organic layer in plan view, one of the electrodes has a portion located outside the outer edge of the organic layer, and the outer edge of the organic layer has a portion located outside the outer edge of the other electrode. In other words, the outer edge of the one electrode has a portion protruding from the outer edge of the organic layer, and the outer edge of the organic layer has a portion protruding from the outer edge of the other electrode. This is to prevent contact between both the electrodes, that is, to prevent a short circuit. (Hereinafter, the one electrode, that is, the electrode having its outer edge outside the organic layer is referred to as a "first electrode", and the other electrode, that is, the electrode having its outer edge inside the organic layer is referred to as a "second electrode".) Herein, usually, the organic layer extension part has a width of about 1 mm due to the issue of process tolerance for forming the second electrode on the organic layer. (In a schematic view of an organic solar cell module, it is common to ignore such an organic layer extension part and illustrate the organic solar cell module as if it does not include the organic layer extension part. However, unless the treatment for removing the organic layer extension part as described later in the present specification is performed after the formation of the second electrode, the organic layer extension part is usually present with a width of 500 µm or more.)

Unfortunately, the organic compound easily takes in water and oxygen, and the protruding portion of the organic layer may hinder the adhesion to the resin layer or the like laminated on the organic layer. Therefore, the present inventors thought that the portion of the organic layer protruding outside the outer edge of the second electrode might serve as an invasion route for water and oxygen.

The present invention has been made in view of the above-mentioned considerations, and the configuration of the present invention can improve the durability of the photoelectric conversion module, which is an object of the present invention.

### <Organic solar cell module>

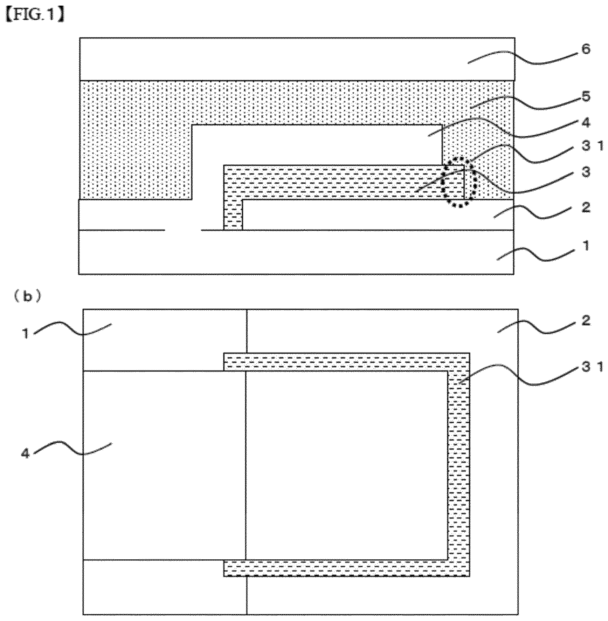

Fig. 1(a) is a schematic cross-sectional view showing an embodiment of an organic solar cell module of the present invention (hereinafter, sometimes simply referred to as a "module"). Fig. 1(b) is a schematic plan view of the organic solar cell module of Fig. 1(a) viewed from a second electrode 4 side, in which a resin layer 5 and a gas barrier layer 6 are omitted.

The organic solar cell module of Fig. 1(a) includes a substrate 1, and a first electrode 2, an organic layer 3 having a photoelectric conversion function, a second electrode 4, the resin layer 5, and the gas barrier layer 6 in this order on the substrate 1. (In general, the term "organic solar cell module" often refers to a module in which a plurality of photovoltaic elements are arranged in series or in parallel, but in the present specification, a module in which only one photovoltaic element is arranged as in Figs. 1(a) and 1(b) is also called an "organic solar cell module".) The portion shown by the round dotted line in the organic layer 3 of Fig. 1(a), that is, a portion 31 visually recognized as the organic layer 3 in Fig. 1(b) showing the plan view of the organic solar cell module, is the organic layer located outside the outer edge of the second electrode. The portion is hereinafter referred to as an "organic layer extension part". Further, in Fig. 1(b), the portion where the first electrode and the second electrode overlap with the organic layer is a portion that substantially contributes to photoelectric conversion, and is hereinafter referred to as an "operating part".

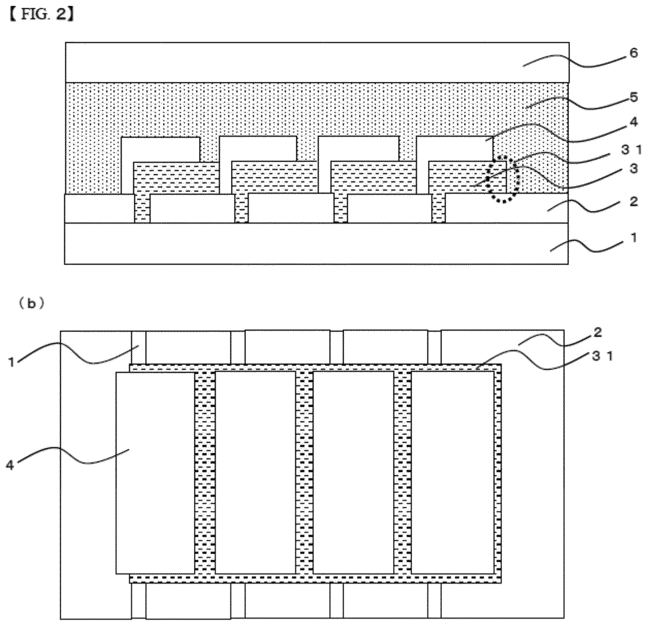

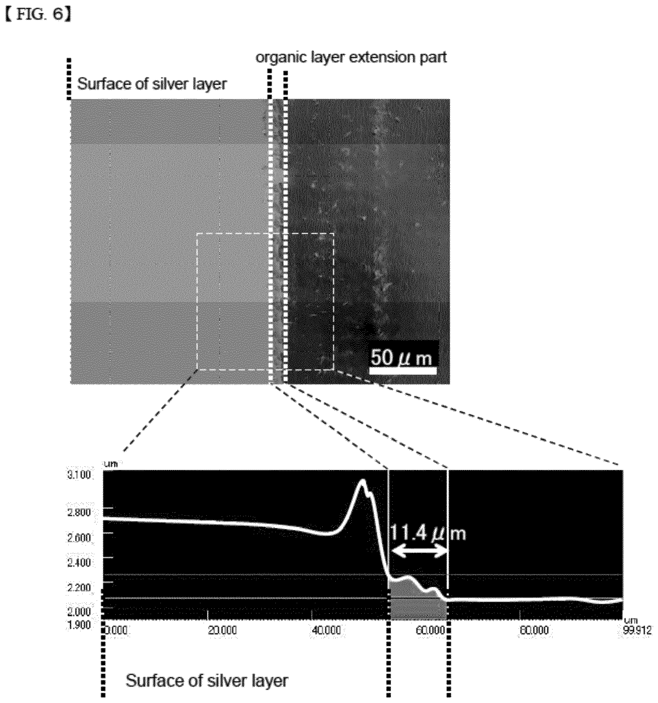

As described above, the organic layer extension part does not contribute to photoelectric conversion, but it is preferable that the organic layer extension part be present to some extent in order to produce a module having a high yield while preventing a short circuit between the electrodes. Meanwhile, since the organic layer extension part may serve as an invasion port for water and oxygen into the operating part, a wide organic layer extension part facing, in particular, the outer edge of the module may promote the deterioration of the photovoltaic element. Herein, the "outer edge of the module" refers to the outermost contour of the module in plan view. For example, to describe with reference to Fig. 1(b), the outer peripheral edge of the substrate 1 is the "outer edge of the module". The organic layer extension part may entirely face the outer edge of the module, for example, as shown in Fig. 1(b). Alternatively, there is a case where both an organic layer extension part facing the outer edge of the module and an organic layer extension part not facing the outer edge of the module (that is, an organic layer extension part present between the operating parts of the photovoltaic elements) are present, for example, as shown in Fig. 2(b). In order to improve the durability of the module, it is important that the organic layer extension part facing the outer edge of the module have a narrow width. The "width of the organic layer extension part" refers to the distance from the outer edge of the second electrode to the outer edge of the organic layer extension part (see Fig. 6), which is obtained by the measurement method described later.

In the organic solar cell module of the present invention, at least the portion of the organic layer extension part facing the outer edge of the module has a size not larger than a certain level, so that deterioration of the photovoltaic element arranged in the module is reduced.

Specifically, in the module of the present invention, the organic layer extension part facing the outer edge of the module has a width of 20 µm or less. The width of the organic layer extension part can be obtained, for example, from a cross-sectional profile obtained by observation with a laser microscope as shown in Fig. 6. Other examples of the method for obtaining the cross-sectional profile include a method of exposing a cross section of the module by processing, and observing the cross section with an electron microscope. Specifically, it is possible to obtain an average cross-sectional profile of a 100 µm field of view, and measure the average width of the part from the outer edge of the second electrode to the outer edge of the organic layer based on the average cross-sectional profile. The lower image of Fig. 6 shows an average cross-sectional profile, which is obtained by evenly dividing a 100 µm field of view in the image obtained by laser microscope observation (upper image) at 180 lines substantially perpendicular to the outer edge of the second electrode, and obtaining the average cross-sectional profile from the cross-sectional profiles obtained at the lines. The number of lines to be drawn in the 100 µm field of view is preferably at least 10 because a larger number of lines increases the accuracy. The number of lines is preferably 100 or more. Alternatively, if the outer edge of the second electrode and the outer edge of the organic layer can be visually recognized by optical microscope observation or electron microscope observation, it is not always necessary to obtain a cross-sectional profile, and it is possible to directly measure the widths of the organic layer extension part in the 100 µm field of view and obtain the average of the widths. In this case as well, the larger the number of lines is, the higher the accuracy is, and therefore at least 10 lines are drawn. If the accuracy is insufficient, 100 or more lines are drawn to obtain the width of the organic layer extension part.

It is preferable that the portion of the organic layer extension part having a width of 20 µm or less be present over the entire range of the organic layer extension part facing the outer edge of the module. Specifically, the portion preferably occupies 80% or more, more preferably 90% or more of the organic layer extension part facing the outer edge of the module. More specifically, it is preferable that, as for arbitrary 10 or more sites in a 100 µm field of view of the organic layer extension part facing the outer edge of the module, the portion of the organic layer extension part having a width of 20 µm or less occupy 80% or more, more preferably 90% or more of the organic layer extension part. Further, it is preferable that the average of the widths of the organic layer extension part facing the outer edge of the module, which are measured at arbitrary 10 or more sites in a 100 µm field of view, be 20 µm or less. The width of the organic layer extension part facing the outer edge of the module is preferably 10 µm or less, more preferably 5 µm or less, because the smaller the width is, the less water and oxygen are taken into the operating part of the photovoltaic element. Meanwhile, as long as the organic layer extension part is present, the lower limit of the width thereof is not particularly limited. However, the width is preferably 0.1 µm or more because if the width is too small, the possibility of a short circuit between the electrodes increases.

Fig. 2(a) is a schematic cross-sectional view showing another embodiment of the module of the present invention. Fig. 2(b) is a schematic plan view of the module of Fig. 1(a) viewed from a second electrode 4 side, in which a resin layer 5 and a gas barrier layer 6 are omitted.

In the embodiment shown in Figs. 2(a) and 2(b), four photovoltaic elements are arranged in series, and each of the photovoltaic elements has an organic layer extension part 31. The organic layer extension parts are formed so that the organic layer extension parts facing the outer edge of the module, that is, the organic layer extension parts 31 located on the upper, right, and lower sides in Fig. 2(b) may all have a width of 20 µm or less. In such a module, invasion of water and oxygen in the cross-sectional direction of the resin layer is considered to occur mainly at the organic layer extension parts facing the outer edge of the module. Therefore, only the organic layer extension parts facing the outer edge of the module are made small, so that a sufficient effect of improving durability is obtained.

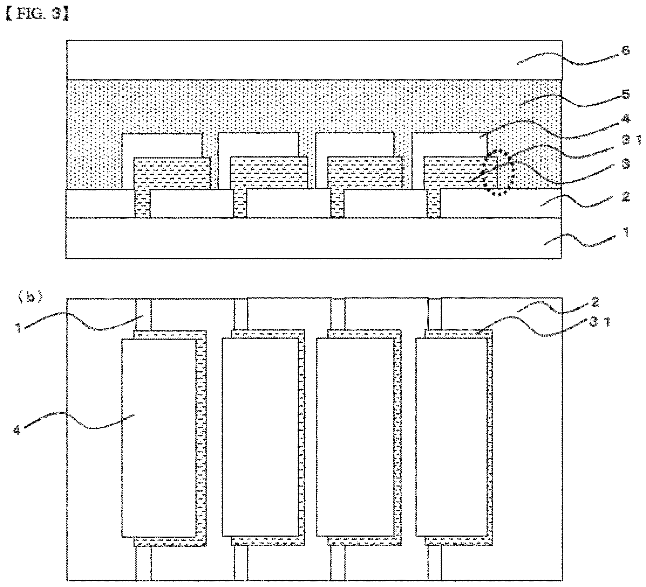

Further, Figs. 3(a) and 3(b) show an example in which, in the module shown in Figs. 2(a) and 2(b), the organic layer extension parts are formed so that the organic layer extension parts not facing the outer edge of the module may also have a width of 20 µm or less, and all the organic layer extension parts of all the photovoltaic elements have a width of 20 µm or less. In this form, it is possible to further improve the durability of the module.

In these aspects as well, the preferable form of the organic layer extension part conforms to the description of the embodiment according to Figs. 1(a) and 1(b).

### [Substrate]

The organic solar cell module of the present invention is usually formed on the substrate 1. The substrate is not particularly limited as long as it is a substrate on which an electrode material and an organic layer can be stacked. It is possible to use a film or a plate produced by an arbitrary method from inorganic materials such as alkali-free glass, quartz glass, aluminum, iron, copper, and alloys including stainless steel, and organic materials such as polyesters, polycarbonates, polyolefins, polyamides, polyimides, polyphenylene sulfide, polyparaxylene polymethyl methacrylate, epoxy resins, and fluororesins. In the case where the organic solar cell module is used with light being incident on the substrate side, it is preferable that each of the above-mentioned substrates have light permeability of about 80%. Further, from the viewpoint of gas barrier properties, a substrate including an organic material and a gas barrier layer formed on the organic material can also be preferably used. The gas barrier layer may be made of an inorganic compound, or a laminated structure of an inorganic compound and an organic compound. Examples of the inorganic compound forming the gas barrier layer include inorganic oxides such as silicon oxide, aluminum oxide, and zinc oxide, and inorganic nitrides such as a silicon nitride film and a silicon oxynitride film.

The module of the present invention may include the substrate 1, or may be peeled off from the substrate 1.

### [Electrodes]

Examples of preferably used materials of the electrodes (the first electrode 2 and the second electrode 4) include metals such as gold, platinum, silver, copper, iron, zinc, tin, aluminum, indium, chromium, nickel, cobalt, scandium, vanadium, yttrium, cerium, samarium, europium, terbium, ytterbium, molybdenum, tungsten, and titanium, as well as metal oxides, composite metal oxides (such as indium tin oxide (ITO), indium zinc oxide (IZO), aluminum zinc oxide (AZO), and gallium zinc oxide (GZO)), alkali metals, and alkaline earth metals (lithium, magnesium, sodium, potassium, calcium, strontium, and barium). Further, electrodes made from an alloy of the above-mentioned metals or a laminate of the above-mentioned metals are also preferably used. Further, the above-mentioned electrode materials may have a form of a mixed layer made from two or more kinds of materials, or may have a laminated structure.

The first electrode 2 or the second electrode 4 of the photovoltaic element has light permeability. It suffices that at least one of the first electrode 2 and the second electrode 4 has light permeability, but both of them may have light permeability. Herein, having light permeability means that an electrode is permeable to light to the extent that incident light reaches the organic layer 3 as a photoelectric conversion layer so that an electromotive force may be generated. That is, when an electrode has a light transmittance value exceeding 0%, the electrode is said to have light permeability. Such a light-permeable electrode preferably has a light transmittance of 60 to 100% in the whole wavelength region of 400 nm or more and 900 nm or less. The thickness of the light-permeable electrode may be any thickness as long as sufficient electric conductivity is obtained, and is preferably 20 nm to 300 nm although it varies depending on the material. Note that a light-impermeable electrode has only to have electric conductivity, and the thickness thereof is also not particularly limited.

### [Organic layer]

The photovoltaic element includes the organic layer 3 between the first electrode 2 and the second electrode 4. As described above, the organic layer 3 is a layer in which 50% or more by number of atoms of the constituent elements are carbon and hydrogen, and the photoelectric conversion layer usually corresponds to the organic layer 3. Alternatively, when a charge extraction layer (an electron extraction layer and/or a hole extraction layer) is a layer in which 50% or more by number of atoms of the constituent elements are carbon and hydrogen, the organic layer 3 means a laminated structure including a combination of the electron extraction layer and/or the hole extraction layer with the photoelectric conversion layer. (In the case of a laminated structure, the outer edge of the outermost layer among the layers that constitute the organic layer is the outer edge of the organic layer.)

Providing the electron extraction layer and the hole extraction layer can form an interface state suitable for extracting carriers. When the material forming the electron extraction layer or the hole extraction layer is a salt (an inorganic salt or an organic salt (for example, an ionic surfactant or PEDOT:PSS resulting from addition of polystyrene sulfonate (PSS) to polyethylene dioxythiophene (PEDOT)), that is, when the organic layer contains a salt, the organic layer has high hygroscopicity and is easily affected by water, so that it is possible to particularly enjoy the effect of the present invention.

The photoelectric conversion layer contains an electron-donating organic semiconductor or an electron-accepting organic semiconductor described later. Examples of the photoelectric conversion layer include a layer made from a mixture of an electron-donating organic semiconductor and an electron-accepting organic semiconductor, a laminated structure of a layer made from an electron-donating organic semiconductor and a layer made from an electron-accepting organic semiconductor, and a laminated structure of a layer made from an electron-donating organic semiconductor, a layer made from an electron-accepting organic semiconductor, and a layer made from a mixture of these semiconductors and provided between the two layers. The photoelectric conversion layer may contain two or more kinds of electron-donating organic semiconductors or electron-accepting organic semiconductors. In addition, it is preferable that the electron-donating organic semiconductor and the electron-accepting organic semiconductor form a mixed layer.

The content ratio between the electron-donating organic semiconductor and the electron-accepting organic semiconductor in the photoelectric conversion layer is not particularly limited, but the weight fraction of electron-donating organic semiconductor : electron-accepting organic semiconductor is preferably in the range of 1 to 99 : 99 to 1, more preferably in the range of 10 to 90 : 90 to 10, still more preferably in the range of 20 to 60 : 80 to 40.

The thickness of the photoelectric conversion layer is required to be a thickness that is sufficient for the electron-donating organic semiconductor and the electron-accepting organic semiconductor to generate photovoltaic power by light absorption. Although the preferable thickness depends on the material, in general, the thickness is preferably 10 nm to 1000 nm, more preferably 50 nm to 500 nm.

The electron-donating organic semiconductor is not particularly limited as long as it is an organic substance that exhibits p-type semiconductor characteristics. Examples of the electron-donating organic semiconductor include: conjugated polymers such as a polythiophene polymer, a 2,1,3-benzothiadiazole-thiophene copolymer, a quinoxaline-thiophene copolymer, a thienothiophene-benzodithiophene copolymer, a thienopyrroledione copolymer, an isoindigo copolymer, a diketopyrrolopyrrole copolymer, a poly-p-phenylene vinylene polymer, a poly-p-phenylene polymer, a polyfluorene polymer, a polypyrrole polymer, a polyaniline polymer, a polyacetylene polymer, and a polythienylenevinylene polymer; and low-molecular organic compounds such as phthalocyanine derivatives including H₂ phthalocyanine (H₂Pc), copper phthalocyanine (CuPc), and zinc phthalocyanine (ZnPc), porphyrin derivatives, triarylamine derivatives including N,N'-diphenyl-N,N'-di(3-methylphenyl)-4,4'-diphenyl-1,1'-diamine (TPD) and N,N'-dinaphthyl-N,N'-diphenyl-4,4'-diphenyl-1,1'-diamine (NPD), carbazole derivatives including 4,4'-di(carbazol-9-yl)biphenyl (CBP), and oligothiophene derivatives (such as terthiophene, quaterthiophene, sexithiophene, and octithiophene). Two or more kinds of these organic substances may be used.

The polythiophene polymer refers to a conjugated polymer having a thiophene skeleton in the main chain, and includes those having a side chain. Specific examples thereof include poly-3-alkylthiophenes such as poly-3-methylthiophene, poly-3-butylthiophene, poly-3-hexylthiophene, poly-3-octylthiophene, and poly-3-decylthiophene, poly-3-alkoxythiophenes such as poly-3-methoxythiophene, poly-3-ethoxythiophene, and poly-3-dodecyloxythiophene, and poly-3-alkoxy-4-alkylthiophenes such as poly-3-methoxy-4-methylthiophene and poly-3-dodecyloxy-4-methylthiophene.

The 2,1,3-benzothiadiazole-thiophene copolymer refers to a conjugated copolymer having a thiophene skeleton and a 2,1,3-benzothiadiazole skeleton in the main chain. Specific examples of the 2,1,3-benzothiadiazole-thiophene copolymer include the following structures. In the following formulae, n represents an integer of 1 to 1000.

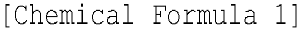

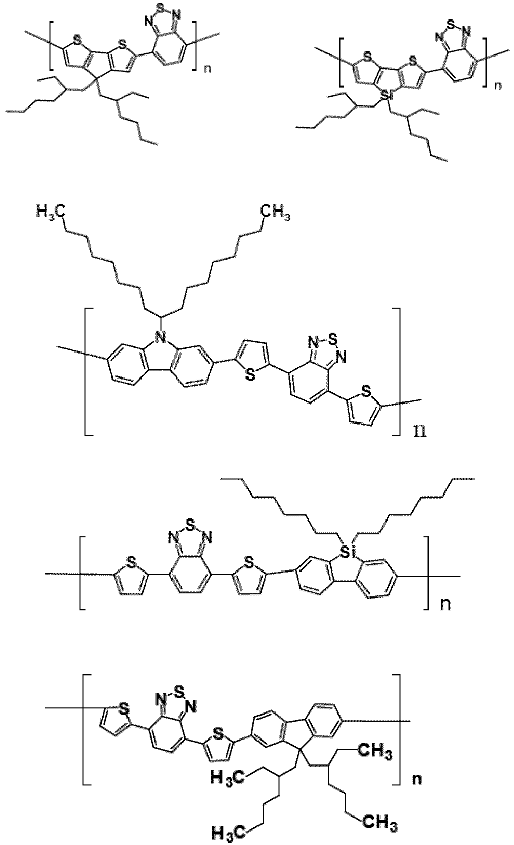

The quinoxaline-thiophene copolymer refers to a conjugated copolymer having a thiophene skeleton and a quinoxaline skeleton in the main chain. Specific examples of the quinoxaline-thiophene copolymer include the following structures. In the following formulae, n represents an integer of 1 to 1000.

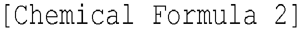

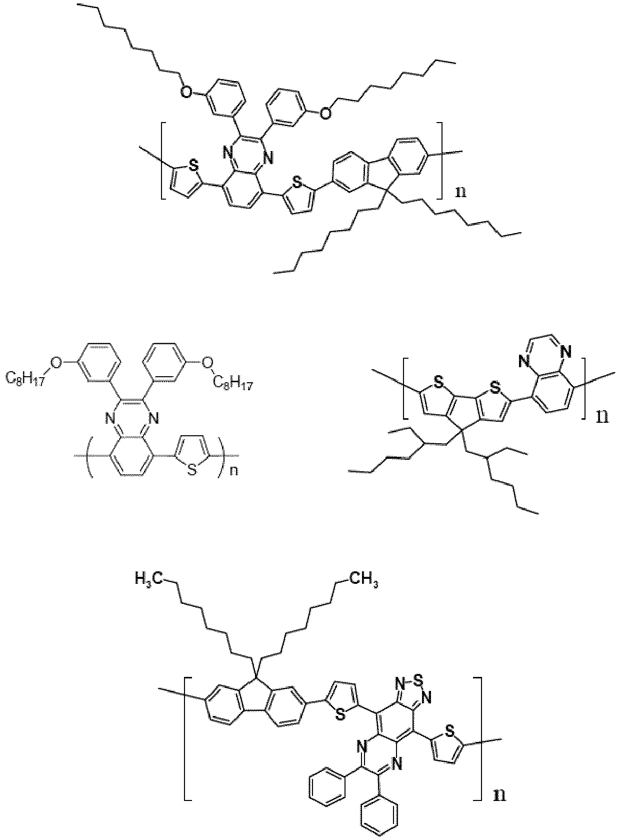

The thienothiophene-benzodithiophene polymer refers to a conjugated copolymer having a thiophene skeleton and a benzodithiophene skeleton in the main chain. Specific examples of the thiophene-benzodithiophene copolymer include the following structures. In the following formulae, n represents an integer of 1 to 1000.

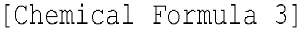

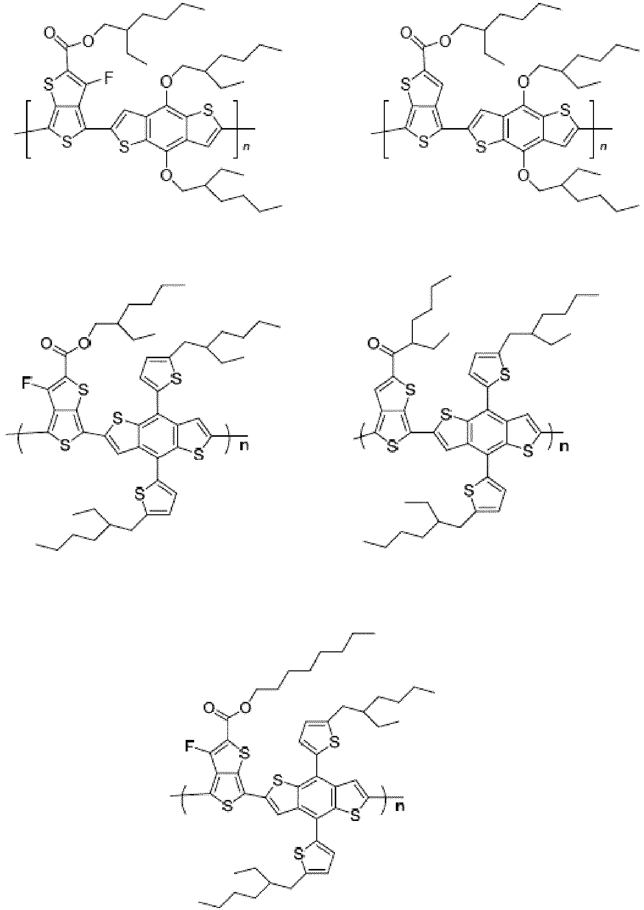

The thienopyrroledione copolymer refers to a conjugated copolymer having a thienopyrroledione skeleton in the main chain. Specific examples of the thienopyrroledione copolymer include the following structures. In the following formulae, n represents an integer of 1 to 1000.

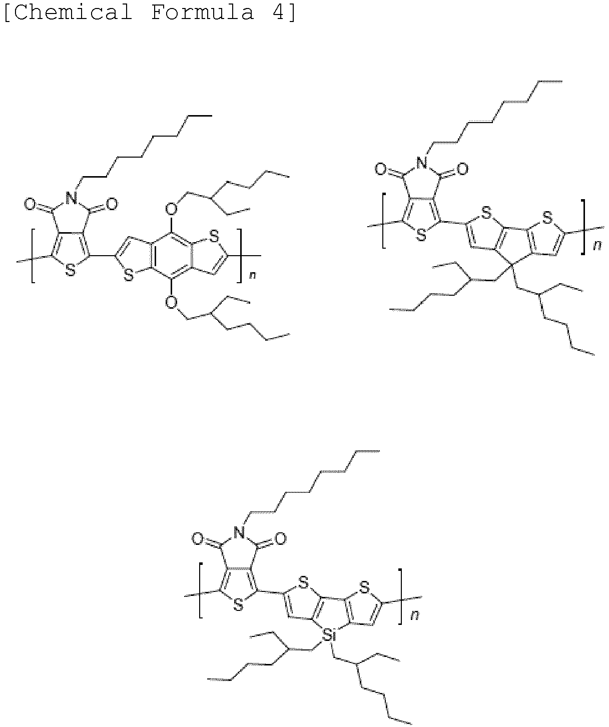

The poly-p-phenylene vinylene polymer refers to a conjugated polymer having a p-phenylene vinylene skeleton in the main chain, and includes those having a side chain. Specific examples thereof include poly[2-methoxy-5-(2-ethylhexyloxy)-1,4-phenylenevinylene] and poly[2-methoxy-5-(3',7'-dimethyloctyloxy)-1,4-phenylenevinylene].

The electron-accepting organic semiconductor is an organic compound that exhibits n-type semiconductor characteristics or has an electron transporting ability, and is not particularly limited as long as it is a compound having these characteristics. Examples of the organic substance that exhibits n-type semiconductor characteristics or has an electron transporting ability include 1,4,5,8-naphthalenetetracarboxylic dianhydride, N,N'-dioctyl-3,4,9,10-naphthyltetracarboxydiimide, perylene derivatives (such as 3,4,9,10-perylenetetracarboxylic dianhydride, perylenediimide derivatives, perylenediimide dimers, and perylenediimide polymers), oxazole derivatives (such as 2-(4-biphenylyl)-5-(4-t-butylphenyl)-1,3,4-oxadiazole and 2,5-di(1-naphthyl)-1,3,4-oxadiazole), triazole derivatives (such as 3-(4-biphenylyl)-4-phenyl-5-(4-t-butylphenyl)-1,2,4-triazole), phenanthroline derivatives, fullerene derivatives, carbon nanotubes, and a derivative obtained by introducing a cyano group into a poly-p-phenylene vinylene polymer (CN-PPV). Two or more kinds of these organic substances may be used. In particular, a fullerene derivative is preferably used since it is an n-type semiconductor that is stable and has high carrier mobility.

Specific examples of the fullerene derivative include unsubstituted derivatives such as C₆₀, C₇₀, C₇₆, C₇₈, C₈₂, C₈₄, C₉₀, and C₉₄ fullerenes, and substituted derivatives such as [6,6]-phenyl C61 butyric acid methyl ester ([6,6]-C61-PCBM or [60]PCBM), [5,6]-phenyl C61 butyric acid methyl ester, [6,6]-phenyl C61 butyric acid hexyl ester, [6,6]-phenyl C61 butyric acid dodecyl ester, and phenyl C71 butyric acid methyl ester ([70]PCBM). In particular, [70]PCBM is more preferable because it has a wide light absorption wavelength region.

Although the electron extraction layer is not essential for the photovoltaic element, it is preferable to provide the electron extraction layer. This is because the electron extraction layer can form an interface state suitable for extracting carriers, and also has an effect of preventing a short circuit between the electrodes.

Examples of the preferably used material forming the electron extraction layer include organic materials that exhibit n-type semiconductor characteristics similarly to the above-mentioned electron-accepting organic materials (such as NTCDA, PTCDA, PTCDI-C8H, oxazole derivatives, triazole derivatives, phenanthroline derivatives, phosphine oxide derivatives, phosphine sulfide derivatives, quinoline derivatives, fullerene compounds, CNTs, and CN-PPV). Moreover, ionic compounds such as ionic substituted fluorene polymers ("Advanced Materials", 2011, vol. 23, pp. 4636-4643, and "Organic Electronics", 2009, vol. 10, pp. 496-500) and combinations of ionic substituted fluorene polymers and substituted thiophene polymers ("Journal of American Chemical Society", 2011, vol. 133, pp. 8416-8419), as well as polyethylene oxide ("Advanced Materials", 2007, vol. 19, pp. 1835-1838) can also be used as the electron extraction layer.

In addition, compounds having an ionic group, such as ammonium salts, amine salts, pyridinium salts, imidazolium salts, phosphonium salts, carboxylate salts, sulfonate salts, phosphate salts, sulfate ester salts, phosphate ester salts, sulfate salts, nitrate salts, acetonate salts, oxoacid salts, and metal complexes can also be used as the electron extraction layer. Specific examples thereof include ammonium chloride, ammonium acetate, ammonium phosphate, hexyltrimethylammonium bromide, tetrabutylammonium bromide, octadecyltrimethylammonium bromide, hexadecylpyridinium bromide, 1-butyl-3-methylimidazolium bromide, tributylhexadecylphosphonium bromide, zinc formate, zinc acetate, zinc propionate, zinc butyrate, zinc oxalate, sodium heptadecafluorononanoate, sodium myristate, sodium benzoate, sodium 1-hexadecanesulfonate, sodium dodecyl sulfate, sodium monododecyl phosphate, zinc acetylacetonate, ammonium chromate, ammonium metavanadate, ammonium molybdate, ammonium zirconium hexafluoride, sodium tungstate, ammonium tetrachlorozincate, tetraisopropyl orthotitanate, lithium nickelate, potassium permanganate, silver phenanthroline complexes, AgTCNQ, and compounds used in an electron extraction layer that are described in Japanese Patent Laid-open Publication No. 2013-58714.

Examples of the inorganic compounds capable of forming the electron extraction layer include metal oxides including titanium oxide (TiOₓ) such as TiO₂, zinc oxide (ZnOₓ) such as ZnO, silicon oxide (SiOₓ) such as SiO₂, tin oxide (SnOₓ) such as SnO₂, tungsten oxide (WOₓ) such as WO₃, tantalum oxide (TaOₓ) such as Ta₂O₃, barium titanate (BaTiₓO_{y}) such as BaTiO₃, barium zirconate (BaZrₓO_{y}) such as BaZrO₃, zirconium oxide (ZrOₓ) such as ZrO₂, hafnium oxide (HfOₓ) such as HfO₂, aluminum oxide (AlOₓ) such as Al₂O₃, yttrium oxide (YOₓ) such as Y₂O₃, and zirconium silicate (ZrSiₓO_{y}) such as ZrSiO₄, nitrides including silicon nitride (SiNₓ) such as Si₃N₄, cadmium sulfide (CdSₓ) such as CdS, zinc selenide (ZnSeₓ) such as ZnSe, zinc sulfide (ZnSₓ) such as ZnS, and cadmium telluride (CdTeₓ) such as CdTe.

Although the hole extraction layer is not essential for the photovoltaic element, it is preferable to provide the hole extraction layer. This is because the hole extraction layer can form an interface state suitable for extracting carriers, and also has an effect of preventing a short circuit between the electrodes.

Examples of the preferably used material forming the hole extraction layer include conductive polymers such as a polythiophene polymer, a poly-p-phenylene vinylene polymer, a polyfluorene polymer, a polypyrrole polymer, a polyaniline polymer, a polyfuran polymer, a polypyridine polymer, and a polycarbazole polymer; low-molecular organic compounds that exhibit p-type semiconductor characteristics, such as phthalocyanine derivatives (such as H₂Pc, CuPc, and ZnPc), porphyrin derivatives, and acene compounds (such as tetracene and pentacene); and carbon compounds such as carbon nanotubes, graphene, and graphene oxide. In particular, polyethylene dioxythiophene (PEDOT) that is a polythiophene polymer, PEDOT to which polystyrene sulfonate (PSS) is added, molybdenum oxide, vanadium oxide, and tungsten oxide are preferably used.

Examples of the inorganic compounds capable of forming the hole extraction layer include molybdenum oxide (MoOₓ) such as MoO₃, tungsten oxide (WOₓ) such as WO₃, nickel oxide (NiOₓ) such as NiO, vanadium oxide (VOₓ) such as V₂O₅, zirconium oxide (ZrOₓ) such as ZrO₂, copper oxide (CuOₓ) such as Cu₂O, copper iodide, ruthenium oxide (RuOₓ) such as RuO₄, and ruthenium oxide (ReOₓ) such as Re₂O₇.

The thickness of the hole extraction layer is preferably 5 nm to 600 nm, more preferably 10 nm to 200 nm.

As described above, the electron extraction layer and the hole extraction layer may contain an inorganic compound. In the present specification, as described above, unless 50% or more by number of atoms of the constituent elements in the layer are carbon and hydrogen, the layer is not included in the "organic layer". This is because such a layer scarcely affects the durability of the module even when it has a wide extension part facing the outer edge of the module.

### [Resin layer]

In the embodiments shown in Figs. 1(a) to 3(b), the resin layer 5 that embeds the organic layer 3 and the second electrode 4 is formed. Although the resin layer is not essential for the organic solar cell module, when the gas barrier layer 6 described later is provided, it is preferable to provide the resin layer for the purpose of improving the flatness to improve the adhesiveness. As for the resin forming the resin layer, a resin capable of achieving the above-mentioned effect can be appropriately selected. Examples of such a resin include thermosetting resins, thermoplastic resins, and photocurable resins. Specific examples thereof include ethylene-vinyl acetate copolymer (EVA) resins, hydrocarbon resins, epoxy resins, polyester resins, acrylic resins, urethane resins, and silicone resins. In addition, an adhesive material that does not cause the above-mentioned curing reaction can also be mentioned. Specific examples thereof include silicone resins, acrylic resins, and polyolefin resins. The resin forming the resin layer is preferably an epoxy resin from the viewpoint of gas barrier properties and adhesiveness. Further, it is also preferable to mix an inorganic compound filler in the resin from the viewpoint of improving the gas barrier properties.

The thickness of the resin layer is preferably small in order to prevent the invasion of water and oxygen in the cross-sectional direction of the resin layer. However, if the resin layer is too thin, there is an increased possibility that the base material and the photovoltaic element come into contact with each other and the element is damaged. Therefore, the thickness of the resin layer is preferably 0.1 µm to 500 µm, more preferably 1 µm to 100 µm.

### [Gas barrier layer]

In the module of the present invention, it is preferable to provide the gas barrier layer 6 in order to efficiently prevent the invasion of water and oxygen from the outside.

Examples of the method for providing the gas barrier layer include a method of joining a gas barrier film made of a resin or glass, and a method of directly forming a film of the gas barrier layer. Further, it is also preferable to directly form a film of the gas barrier layer and then join a gas barrier film on the gas barrier layer in order to further improve the durability.

When an inorganic material is used as a material of the gas barrier film, examples of the material include glass (such as non-alkali glass, quartz glass, and soda glass), alloys of aluminum, iron, copper, stainless steel and the like, inorganic oxides such as silicon oxide, aluminum oxide, and zinc oxide, and inorganic nitrides such as a silicon nitride film and a silicon oxynitride film. From the viewpoint of insulating properties, glass is preferable. The thickness of the gas barrier layer in this case is not particularly limited, but is usually 0.1 µm to 5000 µm, more preferably 1 µm to 1000 µm.

When a resin is used as a material of the gas barrier film, examples of the material include polyesters, polycarbonates, polyolefins, polyamides, polyimides, polyphenylene sulfides, polyparaxylene polymethyl methacrylate, epoxy resins, and fluororesins. The thickness of the gas barrier film made of a resin is not particularly limited, but is usually 1 µm to 100 µm, more preferably 1 µm to 10 µm.

Further, it is also possible to use, as the gas barrier film, a film having a laminated structure of an inorganic compound and a resin.

When a film of the gas barrier layer is directly formed, the material of the gas barrier layer may be an inorganic compound, or may have a laminated structure of an inorganic compound and an organic compound. Examples of the inorganic compound forming the gas barrier layer include inorganic oxides such as silicon oxide, aluminum oxide, and zinc oxide, and inorganic nitrides such as a silicon nitride film and a silicon oxynitride film. The thickness of the gas barrier material formed into a film is not particularly limited, but is usually 0.01 µm to 100 µm, more preferably 0.1 µm to 10 µm.

### <Method for manufacturing organic solar cell module>

In one example, the organic solar cell module of the present invention can be manufactured by a manufacturing method including forming at least a first electrode, an organic layer, and a second electrode in this order, and then removing an organic layer extension part so that in plan view from the second electrode side, a portion of the organic layer extension part facing an outer edge of the organic solar cell module may have a width of 20 µm or less.

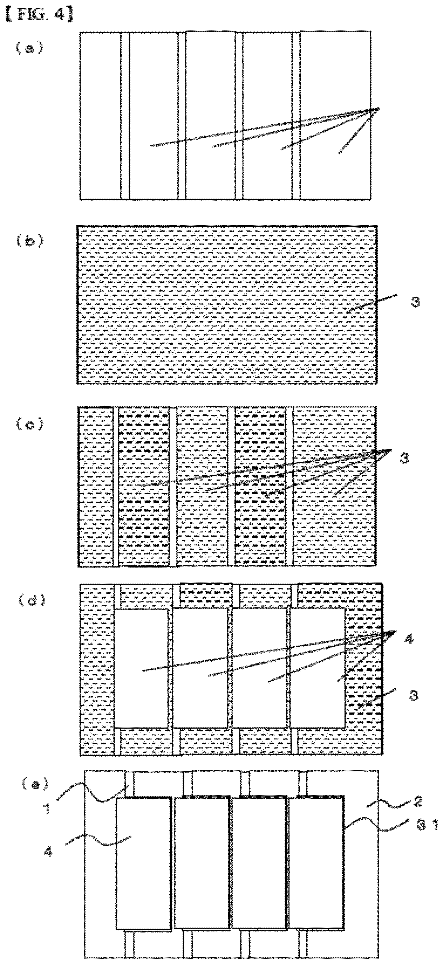

An example of the method for manufacturing the organic solar cell module of the present invention will be described with reference to Figs. 4(a) to 4(e).

First, as shown in Fig. 4(a), a first electrode 2 formed on a substrate 1 by a sputtering method or the like is patterned into a desired shape. The patterning may be performed by wet etching processing via photolithography, laser removal processing, mechanical scribing, or the like.

Then, as shown in Fig. 4(b), an electron extraction layer, a photoelectric conversion layer, a hole extraction layer, and the like are formed on the electrode to form an organic layer 3.

When the electron extraction layer is formed, the electron extraction layer is formed by a solution coating method or the like using zinc oxide, titanium oxide, or the like. When a precursor solution is used, if necessary, it is possible to convert the precursor into zinc oxide, titanium oxide, or the like by firing or the like. When a low-molecular organic substance is used as the electron extraction layer, the electron extraction layer can also be formed by a vacuum deposition method or the like. The solution may be applied by any method such as spin coating, blade coating, slit die coating, screen printing coating, bar coater coating, coating with a mold, a printing and transfer method, an immersion and withdrawal method, an ink jet method, and a spray method. The coating method may be selected according to the quality of the film to be obtained in view of control of the film thickness and orientation.

The photoelectric conversion layer can be formed by dissolving a photoelectric conversion element material containing an electron-donating organic semiconductor material and an electron-accepting organic material in a solvent to prepare a solution, and applying the solution to the first electrode or the electron extraction layer.

In the case of forming the photoelectric conversion layer from a mixture of an electron-donating organic material and an electron-accepting organic material, the electron-donating organic material and the electron-accepting organic material are added to a solvent at a desired ratio, the materials are dissolved by a method such as heating, stirring, or ultrasonic irradiation to form a solution, and the solution is applied to the first electrode or the electron extraction layer. In the case of forming the photoelectric conversion layer by stacking an electron-donating organic material and an electron-accepting organic material, for example, a solution of an electron-donating organic material is applied to form a layer having the electron-donating organic material, and then a solution of an electron-accepting organic material is applied to form a layer. When the electron-donating organic material and the electron-accepting organic material are low-molecular compounds having a molecular weight of about 1000 or less, it is also possible to form a layer by vapor deposition.

For forming the photoelectric conversion layer, the same coating method as that for forming the electron extraction layer can be used. The formation method may be selected according to the photoelectric conversion layer characteristics to be obtained in view of control of the film thickness and orientation. The formed photoelectric conversion layer may be subjected to annealing treatment under reduced pressure or in an inert atmosphere (in a nitrogen or argon atmosphere) in order to remove the solvent.

When the hole extraction layer is provided between the second electrode and the photoelectric conversion layer, a desired material (for example, PEDOT:PSS) is applied to the photoelectric conversion layer, and then the solvent is removed using a vacuum thermostat or a hot plate to form the hole extraction layer. As the coating method, the same coating method as that for forming the electron extraction layer can be used. Further, when an inorganic material such as molybdenum oxide is used, a vacuum deposition method or a sputtering method can be employed.

Then, as shown in Fig. 4(c), the organic layer is patterned for making a series connection with the second electrode to expose the first electrode. The patterning may be performed by wet etching processing via photolithography, laser removal processing, mechanical scribing, or the like.

As shown in Fig. 4(d), the second electrode 4 is formed on the photoelectric conversion layer or the hole extraction layer via formation of a metal electrode made from Ag or the like by a vacuum deposition method or a sputtering method. In this case, use of a mask having an opening in a desired pattern provides an electrode having a desired pattern. In the case where the hole extraction layer is formed by vacuum deposition, it is preferable to successively form the metal electrode while maintaining the vacuum.

In order to manufacture the module of the present invention, as shown in Fig. 4(e), after the formation of the second electrode, the organic layer extension part is removed so that in plan view from the second electrode side, a portion of the organic layer extension part facing an outer edge of the organic solar cell module may have a width of 20 µm or less. The organic layer removal processing can be performed by cleaning with a solvent, laser removal processing, mechanical scribing, or the like. In this case, only the organic layer may be processed so that the organic layer extension part may have a width of 20 µm or less, but in reality, processing is difficult from the viewpoint of processing accuracy. Therefore, it is preferable to process the vicinity of the outer edge of the second electrode and the organic layer at the same time. Further, in the processing, the processing strength is set so that the organic layer may be removed and the second electrode may not be removed. When the processing is performed with such strength, the processing does not completely proceed in a thin portion of the second electrode at the end of the outer edge of the second electrode, and the organic layer partially remains. As a result, the organic layer extension part may have a width of 20 µm or less.

Then, in order to further improve the durability, a resin layer and a gas barrier layer are formed by adhering glass or the like using an epoxy resin or the like. After the resin layer and the gas barrier layer are formed, the resin is cured by UV irradiation or heat treatment according to the curability of the used resin.

In the above description, a method for manufacturing a module has been described in which the first electrode as a cathode is first formed on the substrate, and layers are formed in order from the cathode side. However, it is also possible to form an electrode (anode) on the substrate by a sputtering method or the like, and forming, on the electrode, a hole extraction layer, a photoelectric conversion layer, an electron extraction layer, and an electrode (cathode) in this order.

The organic solar cell module of the present invention can be applied to various photoelectric conversion devices and photovoltaic elements based on a photoelectric conversion function. For example, the organic solar cell module is useful for photovoltaic cells (such as solar cells) and electronic devices (such as various sensors, and electronic equipment such as smartphones) including the photovoltaic cell as a power source, optical sensors (such as illuminance sensors, image sensors, and optical switches), imaging devices, and the like.

### EXAMPLES

Hereinafter, the present invention will be described more specifically by way of examples. It is to be noted that the present invention is not limited to the following examples.

### [Synthesis Example 1]

A conjugated compound (A-1) was synthesized according to the method shown in Formula 1. Incidentally, in the description of Synthesis Example 1, Compound (1-i) was synthesized according to the method described in WO 2014/042090 with reference to the method described in Journal of the American Chemical Society, 2009, vol. 131, pp. 7792-7799, and Compound (1-p) was synthesized according to the same method with reference to the method described in Angewandte Chem International Edition, 2011, vol. 50, pp. 9697-9702.

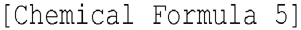

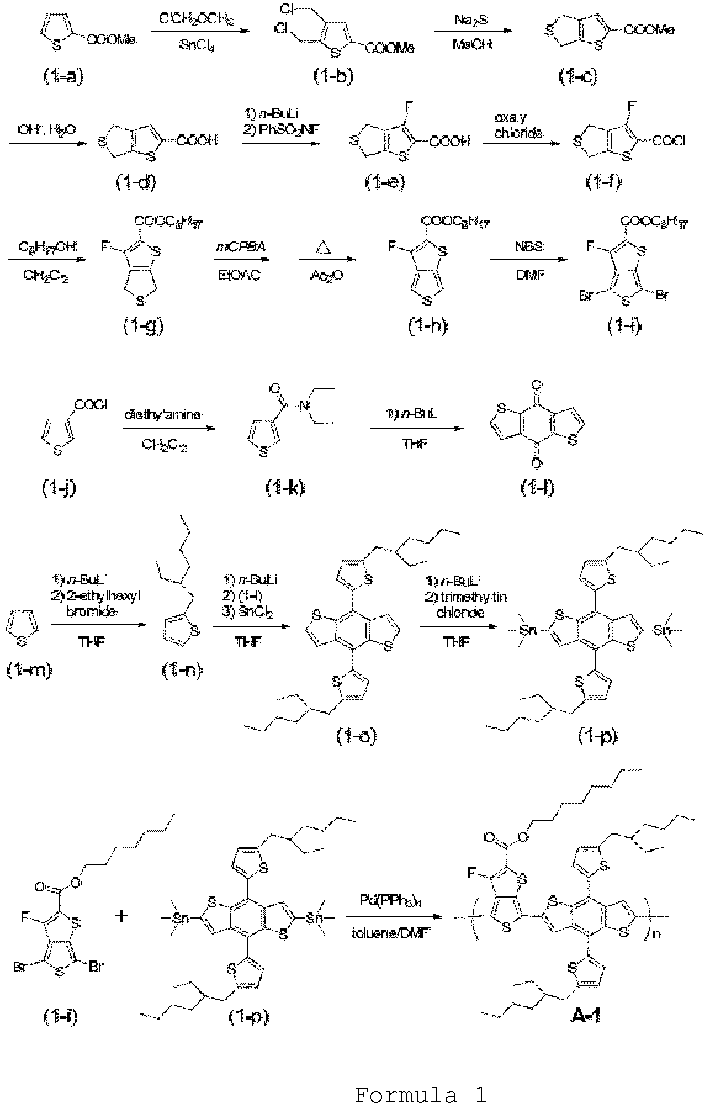

### [Method for measuring width of organic layer extension part]

The vicinity of the outer edge of the second electrode was observed with a laser microscope (VK-9700 manufactured by KEYENCE CORPORATION), and the width of the organic layer extension part was determined from the average cross-sectional profile of a 100 µm field of view (the part surrounded by the dotted line in Fig. 6) defined to include the second electrode and the first electrode. Specifically, an average cross-sectional profile of arbitrary 10 sites in the 100 µm field of view was obtained, and the average width of the part from the outer edge of the second electrode to the outer edge of the organic layer was measured. The procedure is described in 1) to 4) below.
1) The vicinity of the outer edge of the second electrode facing the outer edge of the module is observed with a laser microscope, and a laser microscope image of a field of view not less than 100 µm is acquired.
2) In the acquired image, an arbitrary 100 µm field of view including the organic layer extension part is determined. In this case, the 100 µm field of view is determined so that two sides of the field of view may be substantially parallel to the outer edge of the second electrode.
3) In the determined 100 µm field of view, lines are evenly drawn so as to be substantially perpendicular to the outer edge of the second electrode, a cross-sectional profile at each line is obtained, and an average cross-sectional profile is obtained.
4) The distance from the outer edge of the second electrode to the outer edge of the organic layer is measured from the average cross-sectional profile, and regarded as the width of the organic layer extension part.

The average cross-sectional profile was obtained by calculation using the software attached to VK-9700 manufactured by KEYENCE CORPORATION.

In this example, the average cross-sectional profile was the average of the cross-sectional profiles that were obtained by evenly dividing, at 180 lines, the 100 µm field of view of the image obtained by laser microscope observation.

### [Example 1]

In a sample bottle, 2.7 mg of the compound (A-1), [6,6]-phenyl C61 butyric acid methyl ester (PCBM) (manufactured by Frontier Carbon Corporation), 10 mg of 3,4,5-trimethoxytoluene (manufactured by Tokyo Chemical Industry Co., Ltd.), and 0.19 mL of chloroform were charged, and the container containing the solution was irradiated with ultrasonic waves for 30 minutes in an ultrasonic cleaner (US-2 (trade name) manufactured by Iuchi Seieido Co., Ltd., output: 120 W) to produce a solution A for forming a photoelectric conversion layer.

In a sample bottle containing 10 mg of zinc acetate dihydrate (manufactured by Wako Pure Chemical Industries, Ltd.), 0.5 mL of an ethanol solvent (manufactured by Wako Pure Chemical Industries, Ltd.) was added and dissolved by heat, and 3-aminopropropyltriethoxysilane (manufactured by Wako Pure Chemical Industries, Ltd.) was added at a percentage of 1% by volume to produce a precursor solution B for forming an electron extraction layer.

In a sample bottle, 4.0 mL of a PEDOT:PSS solution (CLEVIOS (registered trademark) P VP AI4083), 3.5 mL of water, 2.5 mL of isopropyl alcohol, and 0.1 mg of a surfactant (EMULGEN (registered trademark) 103 manufactured by Kao Corporation) were charged and stirred to produce a solution C for forming a hole extraction layer.

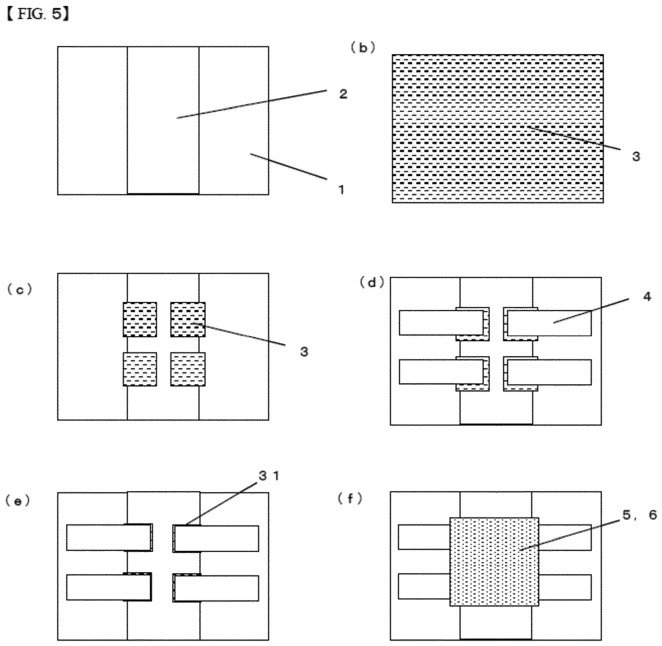

Hereinafter, a process for manufacturing an organic solar cell module will be described with reference to Figs. 5(a) to 5(f). First, a glass substrate 1, on which an ITO transparent conductive layer having a thickness of 125 nm and serving as a first electrode 2 was deposited by a sputtering method, was cut into 38 mm × 46 mm, and the ITO transparent conductive layer was patterned into a rectangular shape of 38 mm × 13 mm by photolithography (Fig. 5(a)). The obtained substrate was subjected to ultrasonic cleaning with an alkaline cleaning liquid ("Semico Clean" (registered trademark) EL56 (trade name) manufactured by Furuuchi Chemical Corporation) for 10 minutes, and then washed with pure water.

The substrate was subjected to UV/ozone treatment for 30 minutes, and then the solution B was dropped on the ITO layer and applied by spin coating at 3000 rpm. The substrate was heated on a hot plate at 100°C for 30 minutes to form an electron extraction layer having a thickness of about 30 nm.

Then, the substrate was transferred to a glove box under a nitrogen atmosphere, and the solution A was dropped on the electron extraction layer and applied by spin coating at 1000 rpm. The substrate was heated on a hot plate at 80°C for 5 minutes to form a photoelectric conversion layer having a thickness of 300 nm.

Further, the solution C was dropped on the photoelectric conversion layer and applied by spin coating at 2000 rpm, and the substrate was heated on a hot plate at 80°C for 1 minute to form a hole extraction layer having a thickness of 40 nm (Fig. 5(b)).

Then, using a laser (wavelength: 355 nm, frequency: 60 kHz, processing speed: 600 mm/sec), the resulting organic layer was removed so that organic layers 3 (in this case, layers each including the photoelectric conversion layer, the hole extraction layer, and the electron extraction layer) each having a size of 6 mm × 6 mm might be obtained (Fig. 5(c)).

Then, the substrate having the photoelectric conversion layers formed thereon and a cathode mask were placed in a vacuum deposition apparatus, the apparatus was evacuated again until the degree of vacuum in the apparatus reached 1 × 10⁻³ Pa or less, and silver layers having a thickness of 200 nm and serving as second electrodes 4 were vapor-deposited by a resistance heating method (Fig. 5(d)). In this case, the parts each having a size of 5 mm × 5 mm, in which the ITO layer and the silver layer overlap with the organic layer interposed therebetween, are the operating parts of the photovoltaic elements.

Then, the silver layers and the organic layers (in this case, the photoelectric conversion layers and the hole extraction layers) were irradiated with a laser (wavelength: 355 nm, frequency: 80 kHz, processing speed: 1000 mm/sec), so that organic layer extension parts located outside the outer edges of the silver layers in plan view were removed (Fig. 5(e)). In this case, the processing direction by the laser scan was parallel to the outer edges of the silver layers, and the processing was performed by scanning in only one direction. The width of each of the organic layer extension parts facing the outer edge of the module was measured by the method for measuring the width of the organic layer extension part described above. The width of each of the organic layer extension parts was 11.4 µm.

Then, the substrate was transferred to a glove box under a nitrogen atmosphere, a photocurable resin (XNR5570 manufactured by Nagase ChemteX Corporation) was applied to a glass material (a base material of a gas barrier layer 6) having a size of 20 mm × 20 mm, and the base material was attached to the center of the substrate (Fig. 5(f)). Then, the resulting laminate was irradiated with ultraviolet light (wavelength: 365 nm, intensity: 100 mWcm⁻²) for 1 minute, and then the laminate was heated on a hot plate at 100°C for 30 minutes to cure the resin, whereby a resin layer 5 was produced.

The first and second electrodes of the photoelectric conversion element manufactured in this way were connected to a 2400 series source meter manufactured by TEKTRONIX, INC., and the module was irradiated with a neutral white LED (LDA4N-G/Z40E/S/W manufactured by Panasonic Corporation) from the ITO layer side in the atmosphere. The current value when the applied voltage was changed from -1 V to +2 V was measured to obtain the initial maximum power generation amount. (Herein, the maximum power generation amount is the product of the current density and the applied voltage at the point where the product of the current density and the applied voltage is the maximum between an applied voltage of 0 V to the open circuit voltage.)

Then, the module was put in an oven having a temperature of 85°C and a relative humidity of 85%. The module was taken out at regular intervals, and the above-mentioned maximum power generation amount was measured to examine the deterioration with time. As a result, the time for which 90% of the power generation amount was maintained was 350 hours.

### [Example 2]

The process until the formation of the silver layers was carried out in the same manner as in Example 1, and the silver layers and the organic layers (in this case, the photoelectric conversion layers and the hole extraction layers) were irradiated with a laser (wavelength: 355 nm, frequency: 80 kHz, processing speed: 1000 mm/sec), so that organic layer extension parts located outside the outer edges of the silver layers were removed. In this case, the processing direction by the laser scan was parallel to the outer edges of the silver layers, and the processing was performed by scanning in both the directions (reciprocating direction). In this way, the laser processing scan speed is increased, so that the processing strength is stronger than in processing in one direction. The width of each of the obtained organic layer extension parts was 3.5 µm.

### [Comparative Example 1]

A module was produced in the same manner as in Example 1 except that after the formation of the silver layers, the organic layer removal processing by a laser was not performed.

### [Comparative Example 2]

The process until the formation of the silver layers was carried out in the same manner as in Example 1 except that after the formation of the organic layer, the organic layer was removed by a laser so that organic layers each having a size of 8 mm × 8 mm might be obtained.

Then, a module was produced in the same manner as in Example 1 except that after the formation of the silver layers, the organic layer removal processing by a laser was not performed.

### [Comparative Example 3]

The process until the formation of the silver layers was carried out in the same manner as in Example 1 except that after the formation of the organic layer, the organic layer was removed by a laser so that organic layers each having a size of 5 mm × 5 mm might be obtained. Herein, in view of the design, the width of the organic layer extension part is 0 µm.

Then, a module was produced in the same manner as in Example 1 except that after the formation of the silver layers, the organic layer removal processing by a laser was not performed.

### [Comparative Example 4]

The process until the formation of the silver layers was carried out in the same manner as in Example 1 except that after the formation of the organic layer, the organic layer was removed by a laser so that organic layers each having a size of 5.1 mm × 5.1 mm might be obtained. In this case, due to the issue of process tolerance, the substrate and the cathode mask were precisely aligned and then fixed to deposit the silver layers.

Then, a module was produced in the same manner as in Example 1 except that after the formation of the silver layers, the organic layer removal processing by a laser was not performed.

As for the organic solar cell modules produced in each of the examples and comparative examples, the width of the organic layer extension parts and the evaluation results of durability are shown in Table 1.

**[Table 1]**

| | Width of organic layer extension parts facing outer edge of module | 85°C 85% RH test Time for which 90% of maximum power generation amount was maintained |
|---|---|---|
| Example 1 | 11.4 µm | 350 hours |
| Example 2 | 3.5 µm | 420 hours |
| Comparative Example 1 | 500 µm | 250 hours |
| Comparative Example 2 | 1500 µm | 240 hours |
| Comparative Example 3 | 0 µm (Design value) | No photovoltaic power is generated at initial stage due to short circuit |
| Comparative Example 4 | 50 µm | 250 hours |

### DESCRIPTION OF REFERENCE SIGNS

- 1:: Substrate
- 2:: First electrode
- 3:: Organic layer
- 31:: Organic layer extension part
- 4:: Second electrode
- 5:: Resin layer
- 6:: Gas barrier layer

## Claims

1. An organic solar cell module comprising at least one photovoltaic element arranged therein, the photovoltaic element including at least a first electrode, an organic layer, and a second electrode in this order,
wherein the organic layer has an organic layer extension part located inside an outer edge of the first electrode and outside an outer edge of the second electrode, and
in plan view from a second electrode side, a portion of the organic layer extension part facing an outer edge of the organic solar cell module has a width of 20 µm or less.

2. The organic solar cell module according to claim 1, wherein in plan view from the second electrode side, entire organic layer extension part has a width of 20 µm or less.

3. The organic solar cell module according to claim 1 or 2, wherein a material that forms the organic layer contains a salt.

4. The organic solar cell module according to any one of claims 1 to 3, further comprising, in addition to the first electrode, the organic layer, and the second electrode, a resin layer and a gas barrier layer in this order.

5. A method for manufacturing an organic solar cell module, the method comprising:
forming at least a first electrode, an organic layer, and a second electrode in this order; and
then removing an organic layer extension part located inside an outer edge of the first electrode and outside an outer edge of the second electrode so that in plan view from a second electrode side, a portion of the organic layer extension part facing an outer edge of the organic solar cell module has a width of 20 µm or less.

6. An electronic device comprising the organic solar cell module according to any one of claims 1 to 4 as a power source.

7. An optical sensor comprising the organic solar cell module according to any one of claims 1 to 4.

8. An imaging device comprising the organic solar cell module according to any one of claims 1 to 4.
